# EUROPEAN PATENT SPECIFICATION

(11) **EP 1 214 171 B1**
(45) Date of publication and mention of the grant of the patent: **09.03.2011**
(21) Application number: 00957250.4
(22) Date of filing: 14.07.2000
(51) Int. Cl.: B23K 26/40, B32B 3/10, B23K 26/38

(54) **EXCIMER LASER ABLATION PROCESS CONTROL OF MULTILAMINATE MATERIALS**
STEUERUNG EINES VERFAHRENS ZUM EXCIMER-LASERABLATIEREN VON MEHRSCHICHTIGEN LAMINATEN
COMMANDE D'UN PROCESSUS D'ABLATION PAR LASER EXCIMERE DE MATIERES MULTICOUCHES

(30) Priority: 14.07.1999 US 353125
(43) Date of publication of application: 19.06.2002
(73) Proprietor: ARADIGM CORPORATION, Hayward, CA 94545 (US)
(72) Inventor: BESTE, Russell, D., Moutain View, CA 94043 (US)
(74) Representative: Price, Nigel John King
(86) International application number: PCT/US2000/019199
(87) International publication number: WO 2001/005551

(56) References cited:
- EP-A- 0 533 198
- US-A- 5 296 291
- US-A- 5 536 579

## Description

### TECHNICAL FIELD

The invention relates to a process for ablating small holes in to multiple layers of material and particularly to a method of preventing deformation of a layer of material into which holes are drilled via an Excimer LASER.

### BACKGROUND OF THE INVENTION

The use of ablation patterning of various polymeric materials, e.g., polyimides, is known. U.S. Pat. No. 4,508,749, for example, disclosed the use of ultraviolet (U.V.) radiation for etching through a polyimide layer. This patent is primarily directed to producing tapered openings through a polyimide layer for exposing surface areas of an underlying layer of metal. Electrical connections are then made through the openings to the metal layer. U.S. Pat. No. 5,236,551 likewise disclosed ablation etching for patterning a polymeric material layer which is then used as an etch mask for etch patterning, using wet or chemical etchants, an underlying layer of metal.

In a typical ablation process, a beam of laser energy is directed against an exposed surface of a body to be ablated. The laser energy is absorbed by the material and, as a result of photochemical, thermal and other effects, localized explosions of the material occur, driving away, for each explosion, tiny fragments of the material. The process requires that significant amounts of energy be both absorbed and retained within small volumes of the material until sufficient energy is accumulated in each small volume to exceed a threshold energy density at which explosions occur.

Polymeric materials, such as polyimides, are well suited for use in the process because such materials have a high absorptivity for U.V. light while having a relatively low thermal diffusivity for limiting the spread of the absorbed energy away from the volume where the energy was absorbed. Thus, the energy level quickly builds above the required energy density threshold.

When an excimer laser is used, because of the unique optical focusing requirements of the excimer laser it is important to the manufacturing process that the material to be ablated be flat, with a typical peak-to peak roughness of less than about 20 microns, i.e. ± 10 microns for a given ablation operation. This need and others are addressed by the instant invention.

EP-A-0 533 198 discloses a flexible printed substrate comprising an insulating resin layer made up of a low-linear expansion polyimide resin layer and a thermoplastic polyimide resin layer. This insulating resin layer is provided on a metal layer. Metal is selectively removed from the metal layer so as to pattern the metal layer to form a wiring circuit. The linear expansion coefficients of the various layers can be chosen so as to reduce problems with the circuit pattern being disrupted by thermal shrinkage and curling after etching

US-A-5 759 331 (best state of the art) discloses a method of making a multi-layered ceramic component with interlayer conductive-filled via holes, comprising the steps of:
(a) depositing a slurry of a ceramic material onto a plastic carrier tape;
(b) drying the slurry to form a ceramic layer on the plastic carrier tape;
(c) applying a first laser beam to the ceramic layer until a first hole having a first predetermined diameter is formed in the ceramic layer; and
(d) applying a second laser beam to the plastic carrier tape in an area adjacent the first hole in the ceramic layer until a second hole having a second predetermined diameter smaller than the first predetermined diameter is formed in the plastic carrier tape, the second hole communicating with the first hole.

### SUMMARY OF THE INVENTION

According to the present invention there is provided a method of ablating holes in a laminated material, the method comprising:
laminating a first layer to a second layer, wherein said first and second layers have different coefficients of thermal expansion, and wherein said second layer has an interior hole such that when the laminated substrate is formed, a region of the first layer aligned with said hole is not laminated to the second layer and is surrounded by laminated regions; and
directing pulses of LASER energy at said region of said first layer aligned with said hole so as to form holes in said first laser.

In the hereinafter described and illustrated preferred embodiments holes are ablated through a thin film using a LASER. A preferred method involves placing the thin film under such conditions as to cause it to come under tension so as to remove wrinkles that may be present in the film, thereby orienting the surface of the film substantially in a single plane to allow precise and accurate ablation of multiple holes in the film simultaneously by applying laser energy to it.

In one example, a thin layer is laminated with an additional layer to form a laminate under conditions comprising a first temperature, and then pulses of LASER energy are directed at the laminate, under conditions comprising a second temperature, in a manner which results in holes being drilled in the thin layer. The first temperature is different from the second temperature and the thin layer has a coefficient of thermal expansion different from a coefficient of thermal expansion of the additional layer, such that after laminating at the first temperature, the additional layer places the thin layer under tension at the second temperature. The first temperature is greater than the second temperature when the coefficients of thermal expansion of the additional layer is less than that of the thin layer, and *vice versa.*

The thin layer preferably comprises polyimide, while the additional layer can be made of various different materials. However, the principles of the present invention apply equally to thin layers other than polyimide.

When the second temperature is higher than the first, the second temperature may be achieved, at least partially, through absorption of laser energy by the additional layer. Heating or cooling during the ablation process can be achieved or supplemented by heating or cooling an ablation chuck, which interfaces the laminate during the ablation process.

A method of preparing a laminated material for laser ablation is provided, which includes laminating a first layer to a second layer, wherein the first and second layers have different coefficients of thermal expansion, and wherein the second layer has an interior hole such that when the laminated substrate is formed, a region of the first layer aligned with the hole is not laminated to the second layer and is surrounded by laminated regions.

A laminated material is provided , which includes first and second layers, wherein the first and second layers have different coefficients of thermal expansion, and wherein the second layer has an interior hole such that a region of the first layer aligned with said hole is not laminated to the second layer and is surrounded by laminated regions.

### DESCRIPTION OF THE FIGURES

Figure 1 is a top view which schematically shows a drug delivery strip or dosage form for use in an inhalant device.
Figure 2 is a longitudinal sectional view of Figure 1.
Figure 3 is a partial side view of an example of a nozzle lid laminate, prior to a drilling procedure according to the present invention.
Figure 4 is a sectional view of Figure 3 which schematically shows the formation or drilling of holes through the nozzle layer.
Figure 5 is a schematic view of a setup including a laser, mask, objective and target used in an ablation process according to the present invention.
Figure 6 is a schematic of a representative sample of a thin layer having wrinkles.
Figure 7 is a schematic drawing of a nozzle lid laminate held by an ablation chuck in preparation for ablation.

### DETAILED DESCRIPTION OF THE INVENTION

Before the present method of excimer laser ablation process control is described, it is to be understood that this invention is not limited to the particular methodology, devices and formulations described, as such methods, devices and formulations may, of course, vary. It is also to be understood that the terminology used herein is for the purpose of describing particular embodiments only, and is not intended to limit the scope of the present invention which will be limited only by the appended claims.

It must be noted that as used herein and in the appended claims, the singular forms "a," "and," and "the" include plural referents unless the context clearly dictates otherwise. Thus, for example, reference to "a formulation" includes mixtures of different formulations, reference to "an analog" refers to one or mixtures of analogs, and reference to "the method of treatment" includes reference to equivalent steps and methods known to those skilled in the art, and so forth.

Unless defined otherwise, all technical and scientific terms used herein have the same meaning as commonly understood by one of ordinary skill in the art to which this invention belongs. Although any methods, devices and materials similar or equivalent to those described herein can be used in the practice or testing of the invention, the preferred method, devices and materials are now described.

Excimer laser ablation enables precise drilling and/or ablation processes to less than one micron. To be useful, however, many such ablated devices must be laminated to other polymeric materials, whether for structural and/or for functional reasons. Since the ablation process is often very precise, it is useful from a manufacturing point of view in many instances to ablate the polymer after the lamination process. Furthermore, because of the unique optical focusing requirements of the excimer laser it is important to the manufacturing process that the material to be ablated be flat, with a typical peak-to peak roughness of less than about 20 microns, i.e., ± 10 microns for a given ablation operation.

The typical material of choice for excimer laser ablation is polyimide. However, the thermal expansion coefficient of polyamide is about 5 x 10⁻⁶ cm/cm/°C, characterizing it a having the lowest coefficient of thermal expansion of the most commonly used polymers. Since polyimide has the lowest coefficient of expansion of most commonly used polymers, maintaining requisite flatness during an ablation process can be very difficult, as any change in temperature can cause materials (e.g., the polyimide component of the multilaminate) to come under compression. Further, and possibly even a more common occurrence, is that the polyimide layer can become wrinkled during the lamination process, prior to excimer laser treatment. In these scenarios, surface flatness is not maintained and the drilling process becomes imprecise. In order to maintain surface flatness for an ablation operation, it is desirable that the ablated material be under surface tension relative to its laminate layer.

The instant invention addresses this problem in a method which comprises providing a laminated material comprising first and second layers, where the first and second layers have different coefficients of thermal expansion. Referring now to the figures, an example of the present invention is described with application to the formation of a nozzle portion of an inhalant device. However, it is noted that the present invention is, of course, not limited to this particular application, which is merely one specific example of how the inventive process and materials can be used.

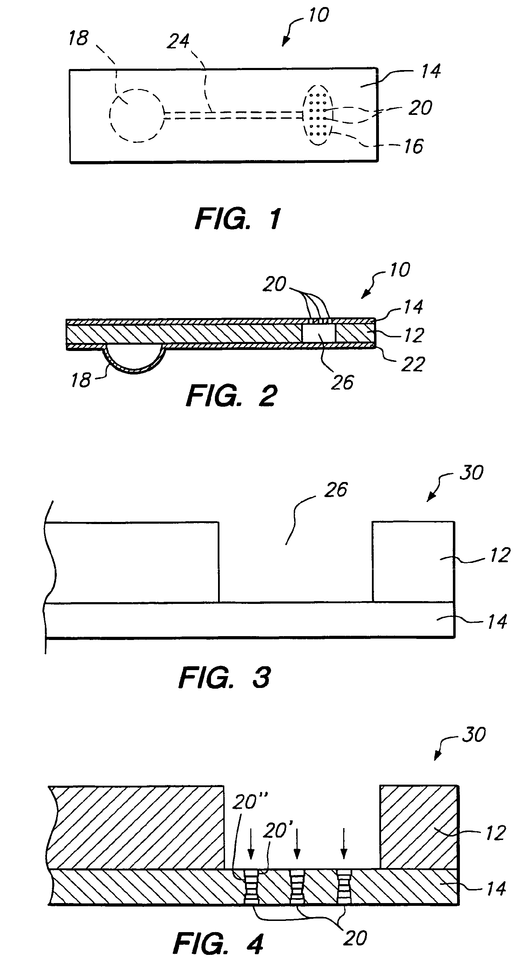

Referring to Figure 1, a top view of a drug delivery strip or dosage form 10 for use in an inhalant device is shown. Dosage form 10 includes a nozzle lid laminate 30, which is a laminate of a lid layer 12 (see Figure 2), such as a metallic strip, e.g., of Aluminum, or other relatively thick layer providing structural support, and a nozzle layer 14 into which nozzle 16 is formed. The nozzle lid laminate 30 is additionally laminated to a blister layer 22. A well 18 is formed in blister layer 22 to provide storage or capacitance for a liquid supply of a drug to be dispensed. A channel 24 interconnects the well 18 with the nozzle 16, and is preferably formed in the blister layer 22.

The blister layer 22 may be formed of ACLAR® (a polychloro trifluoroethylene compound available from Allied Signal), and the well 18 is formed during a deformation processing of the layer 22. The channel 24 may be deformed or etched or otherwise mechanically formed into the film 22.

The nozzle lid laminate 30, in one example, is formed from a top layer or nozzle layer 14 comprising KAPTON® (a polyimide film available from DuPont) which is laminated to a lid layer 12 which, in this case, comprises Aluminum, although other materials could be used as discussed both above and below. As discussed above, the lamination process itself may cause some wrinkling of the nozzle layer 14 as it is laminated to the lid layer 12, which is one of the phenomena that the present invention is designed to address.

Figure 3 is a partial side view of an example of a nozzle lid laminate, prior to a drilling procedure according to the present invention. The lid layer 12 is provided with a hole 26 which, upon interfacing the lid and nozzle layers, outlines the area in which the nozzle 16 is to be formed in the nozzle layer 14. The nozzle layer 14 is provided with a pressure sensitive adhesive (PSA) on the surface which interfaces with the lid layer 12 and bonds the two layers together to form the laminate.

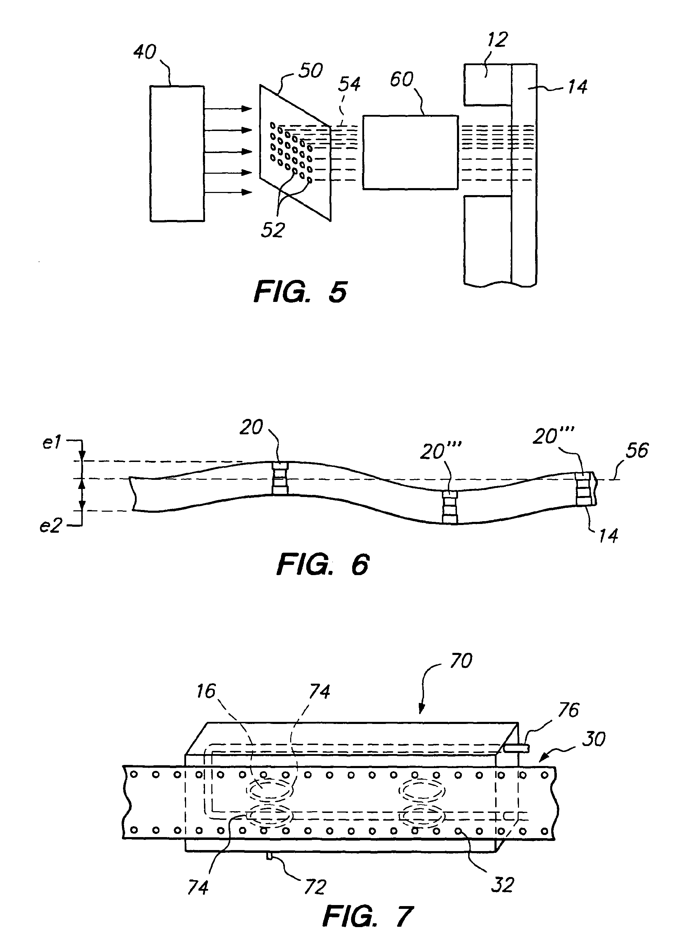

Figure 4 is a sectional view of Figure 3 which schematically shows the formation or drilling of holes 20 through the nozzle layer 14. For simplicity, only three holes are shown in this view, when in actuality an array of hundreds of holes 20 are drilled simultaneously according to the present invention. As schematically shown in Figure 5, a mask 50 is formed with a plurality of through holes 52 which are also arranged in an array that is intended to be formed on the nozzle. The size of the holes 52 correspond to the size of holes 20 to be formed in the nozzle. An excimer laser 40 directs a beam of light having a rectangular cross section, for example perpendicularly against the mask 50. The mask allows only shafts of light 54 through the holes 52, which are arranged in the desired array. The shafts of light 54 are then collimated through an objective lens 60 and focused upon the nozzle layer 14 in the desired nozzle area 16.

The excimer laser ablation process enables precise drilling and/or ablation processes to less than one micron, as noted above. To be useful, the nozzle layer 14 must be substantially flat, with a typical peak-to peak roughness of less than about 20 microns, i.e., ± 10 microns for a given ablation operation. Assuming that the nozzle layer is substantially flat, then the drilling procedure progresses as shown schematically in Figure 4. That is, the shafts of light 54 are focused upon a focal plane that should be coincident with the material that is intended to be ablated, i.e., the surface of the nozzle layer 14. The laser operates under a pulsed frequency, e.g., 300 Hz. With each activation or pulse of the laser 40, the shafts of light 54 etch a portion of the polymer layer that absorbs the energy of the shafts of light and is ablated by it. Thus, for example, the first pulse ablates to a depth 20', the next pulse to a depth 20", and so forth, until enough pulses have been applied to ablate or "drill" all the way through the nozzle layer to form holes 20. The diameter of each layer of ablation can be adjusted by changing, or programming parameters of the laser to change with different pulses (e.g., intensity, or other parameters, as known) so as to shape the through holes 20 to a nozzle shape or other desired conformation. As long as the nozzle layer is flat, the drilling of all holes proceeds simultaneously and the result is a uniform matrix of holes in the nozzle that functions appropriately in delivering an aerosol of medication as intended. For example, with a polyimide layer having a thickness of about 25 µm the application of about 100-125 pulses of the excimer laser operating at a pulse frequency of 300 Hz and 308 nm wavelength will complete the hole drilling procedure. This procedure takes about 400 msec.

However, if the nozzle layer is significantly out of flat, wrinkled, etc. in the area where the nozzle 16 is to be formed, then a malformed matrix results. Fig. 6 is an exaggerated representation of a nozzle layer 14 that is not flat. In order for the polymeric material in the layer 14 to be ablated, it must absorb a sufficient amount of energy from the laser beam, as described above. The only material that absorbs a sufficient amount of energy is that material which is in the location of the focus of the beam. In Figure 6, the phantom line 56 represents the focal plane of the light rays emitted by the excimer laser 40 through mask 50 and focused by objective 60 onto the plane 56. Of course, the plane is incrementally adjusted downwardly with each pulse. When the variation "P1" of the film 14 exceeds 10 microns or P2 exceeds -10 microns, as shown in Figure 6, those portions of the film which are out of the focal plane do not line up properly so as to fully form a through hole 20. These malformed through holes are shown by 20"' in Figure 6. Consequently, the matrix resulting in the nozzle of such a wrinkled film will not contain the intended number of holes and will not evenly distribute the aerosol as intended. Such a result is unacceptable and it is therefor imperative that the film 14 be maintained substantially flat during processing (drilling).

Therefor, it is paramount that the nozzle layer 14 be oriented as completely flat as possible at least in the nozzle forming area, where the drilling process is carried out. As mentioned above, the nozzle layer 14 can develop wrinkles even during the lamination process with the lid layer 12. The lamination of the nozzle layer 14 and the lid layer 12 are performed by a vendor (Plitek, Chicago, Illinois).

One measure which can be taken to eliminate wrinkles that may have been formed during the formation of the nozzle lid laminate is to take advantage of the difference between the coefficients of thermal expansion between the nozzle layer 14 and the lid layer 12. It is important then to choose materials which have at least a 10% difference between the respective coefficients. In the example, where the lid layer 12 comprises aluminum, and the nozzle layer 14 comprises polyimide, the 10% differential is far exceeded. However, these concepts apply to other material or materials, of course. In the instant example, the lamination of the lid layer 12 and the nozzle layer can be accomplished at a reduced temperature, say -5 to -10°C, for example. The drilling process using the excimer laser can then be carried out at an elevated temperature of about 25°C± 5 °C. The physical consequences of these treatments are that, at the reduced temperature, the aluminum layer tends to contract or "shrink" more than the polyimide layer, due to its greater coefficient of thermal expansion. Conversely, after lamination, when the layers are married, and when the temperature is elevated, the aluminum layer expands more than the polyimide layer. However, since the layers are married, the aluminum layer pulls the polyimide layer along with it as it expands. The result is that the polyimide layer is expanded, or stretched out, thereby effectively eliminating wrinkles that may have occurred during the lamination process.

In another example, the lamination may be carried out between an ACLAR layer and a polyimide layer. The thermal coefficient of polyimide is about 5 x 10⁻⁶ cm/cm/°C, whereas the thermal coefficient of ACLAR is about 1 x 10⁻⁴ cm/cm/°C. Since the two thermal coefficients are greater than about 10% different, heating and cooling processes will also be advantageous in eliminating wrinkles from the polyimide layer which may be formed when these materials are laminated. In this example, the lamination process may be carried out at about 25 °C ± 5 °C., and the subsequent ablation (or drilling) process may be carried out at about -5 °C. In this example, a 30 °C temperature differential is created between the subsequent processes. For a 1 cm length sample of this laminate, the temperature differential would cause a change in length of 0.003 cm (30 µm) in the polyamide layer, thereby removing wrinkles in the material, since the polyimide layer shrinks more than the ACLAR layer.

Thus, in an embodiment where cooling of the laminate 30 places the nozzle layer 14 in tension, the lamination process (i.e., process of laminating the nozzle lid laminate) will be conducted at an elevated temperature relative to the temperature at which the material will be drilled or ablated. In an example where polyimide is laminated to polyethylene, upon cooling after the lamination process, the polyethylene shrinks more than the polyimide, thereby putting the polyimide in tension. Typically, in this series of processes, a small window 26, relative to the total size of the laminate 30, is produced or cut out, such that, upon cooling, the window 25 will enlarge and put the nozzle layer 14 (in the target zone where nozzle 16 will be produced) under tension.

Conversely, in an embodiment where heating of the laminate 30 places the nozzle layer 14 in tension, the lamination process (i.e., process of laminating the nozzle lid laminate) will be conducted at a lowered temperature relative to the temperature at which the material will be drilled or ablated. Typically, a large window 26 relative to the total size of the laminate 30 is provided, such that the laminate heating results in window size growth, thereby placing the polyimide in tension.

In order to control the temperature of the nozzle lid laminate 30 during the ablation process, heating or cooling of an ablation chuck 70 may be employed as shown in Figure 7. An ablation chuck 70 is used to position the nozzle lid laminate 30 accurately under the path of the excimer laser beam during the ablation process. Sprocket holes 32 or other drive engaging means are provided in at least the lid layer 12 of the nozzle lid laminate 30 and are used to drive the laminate 30 during processing. The portion of the laminate 30 that is to be ablated is positioned over the ablation chuck 70, after which a vacuum is applied though vacuum port 72 and the laminate 30 is drawn flat against and secured to the chuck 70. The chuck includes wells 74 over which the nozzle portions 16 of the nozzle layer 14 are positioned. Wells 74 provide space surrounding the nozzle portions so that the chuck does not interfere with the ablation process. The wells 74 are also sealed off from the vacuum seal between the chuck 70 and the laminate 30.

In order to cool or heat the environment of the laminate 30, the chuck 70 may be provided with various heat exchange arrangement, such as the plumbing system 76 shown in Figure 7, for example. When using a plumbing system, a coolant, such as liquid nitrogen, for example, could be circulated though the block of the chuck 70 to effectively cool the laminate to the desired operating temperature. Alternatively, a heated fluid, such as a heated oil can be circulated through the plumbing system 76 to elevate the laminate to a desired operating temperature. Alternative heating methods can be used, such as electrical resistance type heating, etc. which can be applied directly to the block.

After ablating the holes 20 into the nozzle layer 14 to form the nozzle 16, the vacuum is released from the chuck 70 and the nozzle lid layer is advanced beyond the chuck 70, where it is mated with and laminated to a blister layer 22 to complete the dosage form 10, as shown in Figure 2.

The temperature variations between the processes of laminating the nozzle lid layer 30 and ablating the nozzle 16 place the target region of the nozzle layer 14 under tension to effectively remove wrinkles in the target region for accurate formation of the nozzle 16, as described above.

## Claims

1. A method of ablating holes in a laminated material, the method comprising:
laminating a first layer (14) to a second layer (12), wherein said first and second layers have different coefficients of thermal expansion, and wherein said second layer has an interior hole (26) such that when the laminated substrate (30) is formed, a region of the first layer aligned with said hole is not laminated to the second layer and is surrounded by laminated regions; and
directing pulses of LASER energy (54) at said region of said first layer aligned with said hole so as to form holes (20) in said first layer.

2. A method as claimed in claim 1, wherein said first layer (14) is laminated to said second layer (12) under conditions comprising a first temperature, wherein said pulses of LASER energy (54) are directed at the laminated substrate (30) under conditions comprising a second temperature, and wherein the first temperature is different from the second temperature and said coefficients of thermal expansion of said first and second layers are such that, after said laminating at said first temperature, said second layer places said first layer under tension at said second temperature.

3. A method as claimed in claim 2, wherein said first temperature is greater than said second temperature and said coefficient of thermal expansion of said second layer (12) is less than said coefficient of thermal expansion of said first layer (14).

4. A method as claimed in claim 3, wherein said first temperature is about 25° ± 5°C and said second temperature is in a range of from about -5 to -10°C.

5. A method as claimed in claim 3, wherein said first layer (14) has a coefficient of thermal expansion which is about 10% or more greater than the coefficient of thermal expansion of said second layer (12).

6. A method as claimed in any one of claims 3 to 5, wherein said first layer (14) comprises polyimide and said second layer (12) comprises ACLAR.

7. A method as claimed in claim 2, wherein said first temperature is less than said second temperature and said coefficient of thermal expansion of said second layer (12) is greater than said coefficient of thermal expansion of said first layer (14).

8. A method as claimed in claim 7, wherein said first temperature is about -5 to 10°C and said second temperature is about 25 °C.

9. A method as claimed in claim 7, wherein said second layer (12) has a coefficient of thermal expansion which is about 10% or more greater than the coefficient of thermal expansion of said first layer (14).

10. A method as claimed in any one of claims 7 to 9, wherein said first layer (14) comprises polyimide and said second layer (12) comprises aluminum.

11. The method of claim 7, wherein said second temperature is achieved, at least partially, by absorption of laser energy by said second layer (12).

12. A method as claimed in claim 7, further comprising heating an ablation chuck (70), which interfaces the laminated substrate (30) during said directing pulses, to achieve said second temperature.

13. A method as claimed in claim 12, wherein said heating comprises circulating a heated fluid through the chuck (70).

14. A method as claimed in claim 12, wherein said heating comprises heating the chuck by resistive electrical heating.

15. A method as claimed in claim 3, further comprising cooling an ablation chuck (70), which interfaces the laminated substrate (30) during said directing pulses, to achieve said second temperature.

16. A method as claimed in claim 15, wherein said cooling comprises circulating a coolant through the chuck.

17. A method as claimed in claim 16, wherein said coolant comprises liquid nitrogen.

18. A method as claimed in claim 1, wherein the said second layer (12) has a higher coefficient of thermal expansion than the first layer (14) and wherein the method further comprises allowing the second layer to absorb heat from the LASER pulses and expand laterally and thereby provide lateral force against the first layer.

19. A method as claimed in claim 18, wherein the first layer (14) is comprised of a first polymeric material and the second layer (12) is comprised of a second polymeric material different from the first polymeric material.

20. A method as claimed in claim 1, further comprising changing the temperature of the laminated substrate (30) so as to place under tension said region of said first layer (14) aligned with said hole (26), prior to said directing of said pulses of LASER energy (54).

21. A method as claimed in claim 20, wherein the coefficient of thermal expansion of the first layer (14) is greater than that of the second layer (12).

22. A method as claimed in claim 20, wherein the coefficient of thermal expansion of the second layer (12) is greater than that of the first layer (14).

23. A method as claimed in claim 1, wherein the first layer (14) has a coefficient of thermal expansion which is about 10% or more greater than the coefficient of thermal expansion of the second layer (12).

24. A method as claimed in claim 1, wherein the first layer (14) comprises polyimide.

25. A method as claimed in claim 24, wherein the second layer (12) comprises ACLAR.

26. A method as claimed in claim 24, wherein the second layer (12) comprises aluminum.

## Patentansprüche

1. Verfahren zum Bilden von Löchern in einem laminierten Material durch Abtragen, wobei das Verfahren umfasst:
Laminieren einer ersten Schicht (14) an eine zweite Schicht (12), wobei die erste und die zweite Schicht verschiedene Wärmeausdehnungskoeffizienten aufweisen und wobei die zweite Schicht ein Innenloch (26) aufweist, derart, dass dann, wenn das laminierte Substrat (30) gebildet wird, ein Bereich der ersten Schicht, der mit dem Loch ausgerichtet ist, nicht an die zweite Schicht laminiert wird und von laminierten Bereichen umgeben ist, und
Richten von Impulsen von LASER-Energie (54) auf den Bereich der ersten Schicht, der mit dem Loch ausgerichtet ist, so dass Löcher (20) in der ersten Schicht gebildet werden.

2. Verfahren nach Anspruch 1, bei dem die erste Schicht (14) unter Bedingungen, die eine erste Temperatur umfassen, an die zweite Schicht (12) laminiert wird, wobei die Impulse von LASER-Energie (54) unter Bedingungen, die eine zweite Temperatur umfassen, auf das laminierte Substrat (30) gerichtet werden, und wobei die erste Temperatur von der zweiten Temperatur verschieden ist und die Wärmeausdehnungskoeffizienten der ersten und der zweiten Schicht derart sind, dass die zweite Schicht nach dem Laminieren bei der ersten Temperatur die erste Schicht bei der zweiten Temperatur unter Spannung setzt.

3. Verfahren nach Anspruch 2, bei dem die erste Temperatur höher als die zweite Temperatur ist und der Wärmeausdehnungskoeffizient der zweiten Schicht (12) kleiner als der Wärmeausdehnungskoeffizient der ersten Schicht (14) ist.

4. Verfahren nach Anspruch 3, bei dem die erste Temperatur etwa 25 ° ± 5 °C beträgt und die zweite Temperatur in einem Bereich von etwa -5 bis -10 °C liegt.

5. Verfahren nach Anspruch 3, bei dem die erste Schicht (14) einen Wärmeausdehnungskoeffizienten aufweist, der etwa 10 % oder mehr größer ist als der Wärmeausdehnungskoeffizient der zweiten Schicht (12).

6. Verfahren nach einem der Ansprüche 3 bis 5, bei dem die erste Schicht (14) Polyimid umfasst und die zweite Schicht (12) ACLAR umfasst.

7. Verfahren nach Anspruch 2, bei dem die erste Temperatur niedriger als die zweite Temperatur ist und der Wärmeausdehnungskoeffizient der zweiten Schicht (12) größer als der Wärmeausdehnungskoeffizient der ersten Schicht (14) ist.

8. Verfahren nach Anspruch 7, bei dem die erste Temperatur etwa -5 bis -10 °C beträgt und die zweite Temperatur etwa 25 °C beträgt.

9. Verfahren nach Anspruch 7, bei dem die zweite Schicht (12) einen Wärmeausdehnungskoeffizienten aufweist, der etwa 10 % oder mehr größer ist als der Wärmeausdehnungskoeffizient der ersten Schicht (14).

10. Verfahren nach einem der Ansprüche 7 bis 9, bei dem die erste Schicht (14) Polyimid umfasst und die zweite Schicht (12) Aluminium umfasst.

11. Verfahren nach Anspruch 7, bei dem die zweite Temperatur zumindest teilweise durch Absorption von Laserenergie durch die zweite Schicht (12) erreicht wird.

12. Verfahren nach Anspruch 7, das zum Erreichen der zweiten Temperatur ferner das Erwärmen einer Abtragefixiervorrichtung (70) umfasst, die das laminierte Substrat (30) während des Richtens von Impulsen berührt.

13. Verfahren nach Anspruch 12, bei dem das Erwärmen das Umwälzen eines erwärmten Fluids durch die Fixiervorrichtung (70) umfasst.

14. Verfahren nach Anspruch 12, bei dem das Erwärmen das Erwärmen der Fixiervorrichtung durch elektrisches Widerstandsheizen umfasst.

15. Verfahren nach Anspruch 3, das zum Erreichen der zweiten Temperatur ferner das Kühlen einer Abtragefixiervorrichtung (70) umfasst, die das laminierte Substrat (30) während des Richtens von Impulsen berührt.

16. Verfahren nach Anspruch 15, bei dem das Kühlen das Umwälzen eines Kühlmittels durch die Fixiervorrichtung umfasst.

17. Verfahren nach Anspruch 16, bei dem das Kühlmittel flüssigen Stickstoff umfasst.

18. Verfahren nach Anspruch 1, bei dem die zweite Schicht (12) einen höheren Wärmeausdehnungskoeffizienten als die erste Schicht (14) aufweist und wobei das Verfahren ferner das Zulassen des Absorbierens von Wärme von den LASER-Impulsen durch die zweite Schicht und des seitlichen Ausdehnens der zweiten Schicht umfasst, wodurch eine seitliche Kraft gegen die erste Schicht bereitgestellt wird.

19. Verfahren nach Anspruch 18, bei dem die erste Schicht (14) ein erstes polymeres Material umfasst und die zweite Schicht (12) ein zweites polymeres Material, das von dem ersten polymeren Material verschieden ist, umfasst.

20. Verfahren nach Anspruch 1, das ferner das Ändern der Temperatur des laminierten Substrats (30) umfasst, so dass der Bereich der ersten Schicht (14), der mit dem Loch (26) ausgerichtet ist, vor dem Richten der Impulse der LASER-Energie (54) unter Spannung gesetzt wird.

21. Verfahren nach Anspruch 20, bei dem der Wärmeausdehnungskoeffizient der ersten Schicht (14) größer als derjenige der zweiten Schicht (12) ist.

22. Verfahren nach Anspruch 20, bei dem der Wärmeausdehnungskoeffizient der zweiten Schicht (12) größer als derjenige der ersten Schicht (14) ist.

23. Verfahren nach Anspruch 1, bei dem die erste Schicht (14) einen Wärmeausdehnungskoeffizienten aufweist, der um etwa 10 % oder mehr größer als der Wärmeausdehnungskoeffizient der zweiten Schicht (12) ist.

24. Verfahren nach Anspruch 1, bei dem die erste Schicht (14) Polyimid umfasst.

25. Verfahren nach Anspruch 24, bei dem die zweite Schicht (12) ACLAR umfasst.

26. Verfahren nach Anspruch 24, bei dem die zweite Schicht (12) Aluminium umfasst.

## Revendications

1. Procédé pour produire l'ablation de trous dans un matériau stratifié, le procédé comprenant les opérations suivantes :
superposer une première couche (14) sur une deuxième couche (12), lesdites première et deuxième couches ayant des coefficients de dilatation thermique différents, et ladite deuxième couche comportant un trou intérieur (26) tel que quand le substrat stratifié (30) est formé, une région de la première couche alignée avec ledit trou n'est pas stratifiée sur la deuxième couche et est entourée de régions stratifiées ; et
diriger des impulsions d'énergie laser (54) sur ladite région de ladite première couche alignée avec ledit trou afin de former des trous (20) dans ladite première couche.

2. Procédé selon la revendication 1, dans lequel ladite première couche (14) est stratifiée sur la deuxième couche (12) sous des conditions comprenant une première température, dans lequel lesdites impulsions d'énergie laser (54) sont dirigées vers le substrat stratifié (30) sous des conditions comprenant une deuxième température, et dans lequel la première température est différente de la deuxième température et lesdits coefficients de dilatation thermique desdites première et deuxième couches sont tels que, après ladite stratification à la première température, ladite deuxième couche met ladite première couche en tension à ladite deuxième température.

3. Procédé selon la revendication 2, dans lequel ladite première température est supérieure à ladite deuxième température et ledit coefficient de dilatation thermique de ladite deuxième couche (12) est inférieur audit coefficient de dilatation thermique de ladite première couche (14).

4. Procédé selon la revendication 3, dans lequel ladite première température vaut environ 25° ± 5 °C et ladite deuxième température est comprise dans un intervalle d'environ -5 à -10 °C.

5. Procédé selon la revendication 3, dans lequel ladite première couche (14) a un coefficient de dilatation thermique qui est supérieur d'environ 10 % ou plus au coefficient de dilatation thermique de ladite deuxième couche (12).

6. Procédé selon l'une quelconque des revendications 3 à 5, dans lequel ladite première couche (14) comprend du polyimide et ladite deuxième couche (12) comprend de l'ACLAR.

7. Procédé selon la revendication 2, dans lequel ladite première température est inférieure à ladite deuxième température et ledit coefficient de dilatation thermique de la deuxième couche (12) est supérieur audit coefficient de dilatation thermique de ladite première couche (14).

8. Procédé selon la revendication 7, dans lequel ladite première température vaut environ de -5 à 10 °C et ladite deuxième température vaut environ 25 °C.

9. Procédé selon la revendication 7, dans lequel ladite deuxième couche (12) a un coefficient de dilatation thermique qui est supérieur d'environ 10 % ou plus au coefficient de dilatation thermique de ladite première couche (14).

10. Procédé selon l'une quelconque des revendications 7 à 9, dans lequel ladite première couche (14) comprend du polyimide et ladite deuxième couche (12) comprend de l'aluminium.

11. Procédé selon la revendication 7, dans lequel ladite deuxième température est obtenue, au moins partiellement, par absorption d'énergie laser par ladite deuxième couche (12).

12. Procédé selon la revendication 7, comprenant en outre le fait de chauffer un support d'ablation (70), qui réalise une interface avec le substrat stratifié (30) pendant ladite orientation des impulsions, pour obtenir ladite deuxième température.

13. Procédé selon la revendication 12, dans lequel ledit chauffage comprend le fait de faire circuler un fluide chauffé dans le support (70).

14. Procédé selon la revendication 12, dans lequel ledit chauffage comprend le fait de faire chauffer le support par un chauffage électrique résistif.

15. Procédé selon la revendication 3, comprenant en outre le fait de refroidir un support d'ablation (70), qui réalise une interface avec le substrat stratifié (30) pendant ladite orientation des impulsions, pour obtenir ladite deuxième température.

16. Procédé selon la revendication 15, dans lequel ledit refroidissement comprend le fait de faire circuler un fluide réfrigérant dans le support.

17. Procédé selon la revendication 16, dans lequel ledit fluide réfrigérant comprend de l'azote liquide.

18. Procédé selon la revendication 1, dans lequel ladite deuxième couche (12) a un coefficient de dilatation thermique supérieur à celui de la première couche (14) et dans lequel le procédé comprend en outre le fait de laisser la deuxième couche absorber la chaleur provenant des impulsions laser et se dilater latéralement et d'appliquer ainsi une force latérale contre la première couche.

19. Procédé selon la revendication 18, dans lequel la première couche (14) est constituée d'un premier matériau polymère et la deuxième couche (12) est constituée d'un deuxième matériau polymère, différent du premier matériau polymère.

20. Procédé selon la revendication 1, comprenant en outre le fait de modifier la température du substrat stratifié (30) afin de mettre sous tension ladite région de la première couche (14) alignée avec ledit trou (26), avant de diriger les impulsions d'énergie laser (54).

21. Procédé selon la revendication 20, dans lequel le coefficient de dilatation thermique de la première couche (14) est supérieur à celui de la deuxième couche (12).

22. Procédé selon la revendication 20, dans lequel le coefficient de dilatation thermique de la deuxième couche (12) est supérieur à celui de la première couche (14).

23. Procédé selon la revendication 1, dans lequel la première couche (14) a un coefficient de dilatation thermique qui est supérieur d'environ 10 % ou plus au coefficient de dilatation thermique de la deuxième couche (12).

24. Procédé selon la revendication 1, dans lequel la première couche (14) comprend du polyimide.

25. Procédé selon la revendication 24, dans lequel la deuxième couche (12) comprend de l'ACLAR.

26. Procédé selon la revendication 24, dans lequel la deuxième couche (12) comprend de l'aluminium.
